# EUROPEAN PATENT APPLICATION

(11) **EP 3 767 015 A1**
(43) Date of publication of application: **20.01.2021**
(21) Application number: 19768072.1
(22) Date of filing: 18.02.2019
(51) Int. Cl.: C30B 29/36

(54) **PRODUCTION METHOD AND PRODUCTION DEVICE OF SILICON CARBIDE SINGLE CRYSTAL**

(30) Priority: 16.03.2018 JP 2018049991
(71) Applicant: Shin-Etsu Handotai Co., Ltd., Tokyo 100-0004 (JP)
(72) Inventor: IKEDA Hitoshi, Annaka-shi, Gunma 379-0196 (JP); TAKAHASHI Toru, Annaka-shi, Gunma 379-0196 (JP); AOYAMA Tetsuro, Annaka-shi, Gunma 379-0196 (JP)
(74) Representative: Wibbelmann, Jobst
(86) International application number: PCT/JP2019/005732
(87) International publication number: WO 2019/176447

(57) **Abstract**

The present invention is a method for manufacturing a silicon carbide single crystal by sublimating a silicon carbide raw material to grow a silicon carbide single crystal on a seed crystal substrate in an apparatus for growing a silicon carbide single crystal, the apparatus including at least a growth container and a heat-insulating container that surrounds the growth container and has a hole for temperature measurement. The method includes: measuring a temperature of the growth container via the hole for temperature measurement when the silicon carbide single crystal is grown; and blocking the hole for temperature measurement with a blocking member when the silicon carbide single crystal is cooled after the growth of the silicon carbide single crystal is ended. Consequently, a method and apparatus for manufacturing a silicon carbide single crystal are provided to reduce breaking and cracking of the silicon carbide single crystal ingot and wafer.

## Description

### TECHNICAL FIELD

The present invention relates to a method and apparatus for manufacturing a silicon carbide single crystal in which a silicon carbide single crystal is grown by a sublimation method.

### BACKGROUND ART

Recently, inverter circuits have been commonly used in electric vehicles and electric air-conditioners. This creates demands for semiconductor crystal of silicon carbide (hereinafter may also be referred to as SiC) because of the properties of less power loss and higher breakdown voltage in devices than those using semiconductor Si crystal.

As a typical and practical method for growing a crystal with a high melting point or a crystal that is difficult to grow by liquid phase growth such as SiC, a sublimation method exists. In this method, a solid raw material is sublimated in a container at a high temperature around 2000°C or higher, and a crystal is grown on a seed crystal located on the opposite side (Patent Document 1).

However, SiC crystal growth requires high temperature for the sublimation, and the growth apparatus requires temperature control at the high temperature. Moreover, to stabilize the pressure of the sublimated substance, it is necessary to steadily control the pressure inside the container. Further, SiC crystal growth depends on the sublimation rate, and the growth rate is relatively quite slow in comparison with Czochralski method for Si, LPE manufacturing method for GaAs and so forth, for example. Hence, long time is required for the growth. Fortunately, the developments of control units, computers, personal computers, and so forth nowadays enable long-term steady adjustments of pressure and temperature.

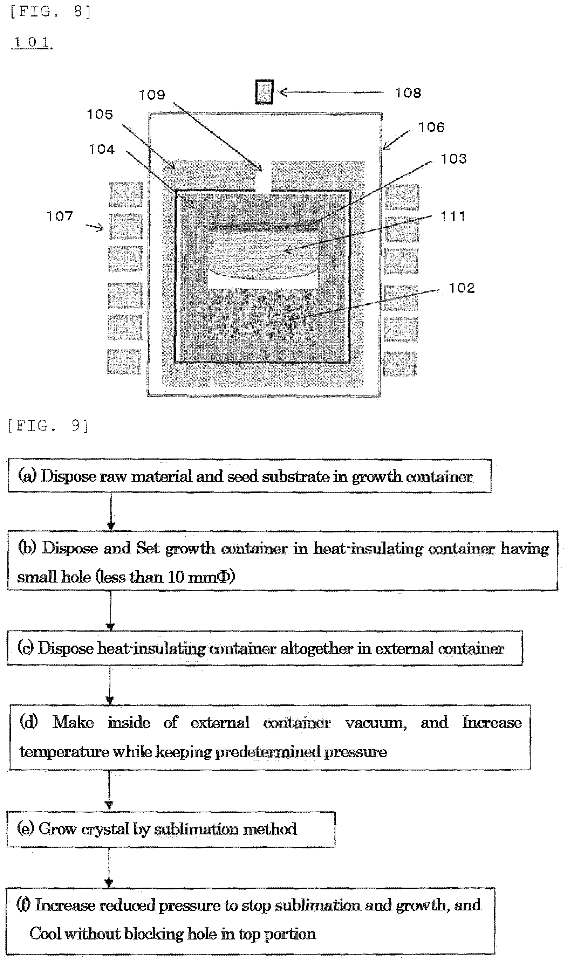

Here, a conventional method and apparatus for manufacturing a SiC single crystal will be described using FIGs. 8, 9.

As shown in FIG. 8, an apparatus 101 for manufacturing a SiC single crystal includes a carbon-graphite growth container 104 having a container main body for housing a SiC raw material 102 and a lid where a SiC seed substrate (also referred to as seed substrate wafer) 103 is disposed. Moreover, the apparatus 101 for manufacturing a SiC single crystal includes a heat-insulating container 105 made of a heat-insulating material outside the growth container 104, and further includes, outside the heat-insulating container 105, an external container 106 such as a quartz tube or a vacuum chamber for reducing the pressure of the growth container 104, and a heater 107 such as a radiofrequency heating coil for heating the SiC raw material 102. Furthermore, the apparatus 101 includes a thermometer 108 such as a temperature-measurement sensor for measuring the temperature inside the growth container 104. The heat-insulating container 105 has a hole 109 for temperature measurement (also referred to as upper-portion temperature measurement hole) in a top portion thereof. Additionally, the apparatus 101 includes a supply port for supplying an inert gas such as Ar and a discharge port for discharging the inert gas, which are not shown, during SiC crystal growth.

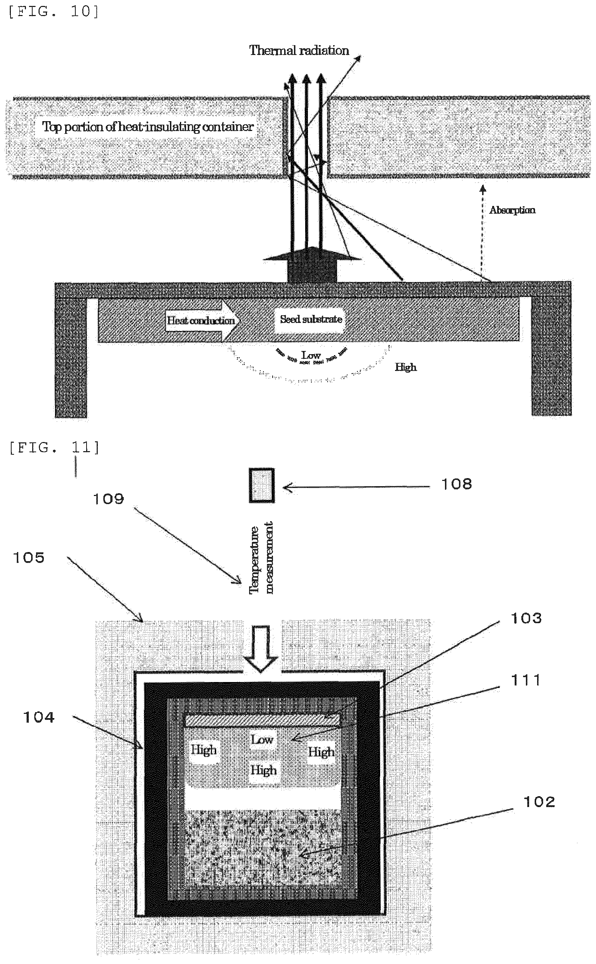

Next, a method for manufacturing SiC will be described using a flowchart in FIG. 9. First, as described in FIG. 9(a), the raw material 102 and the seed substrate 103 are disposed in the growth container 104. Next, as described in FIG. 9(b), the growth container 104 is disposed in the heat-insulating container 105. Next, as described in FIG. 9(c), the heat-insulating container 105 as a whole is disposed in the external container 106. Next, as described in FIG. 9(d), the inside of the external container 106 is made vacuum, and the temperature is raised while a predetermined pressure is being kept. Next, as described in FIG. 9(e), a SiC single crystal is grown by sublimation method. In this event, as shown in FIG. 10, heat escapes by thermal radiation through the hole 109 for temperature measurement, so that the temperature immediately below the hole 109 is the lowest. Hence, the growth starts from this position as the center of the seed, and the SiC single crystal grows in a convex shape according to the temperature distribution.

Finally, as described in FIG. 9(f), the reduced pressure is increased to stop the sublimation and the growth, and the temperature is gradually lowered for cooling. In this event also, a central portion of the grown SiC single crystal ingot is the coolest as shown in FIG. 11.

Note that SiC single crystal includes cubic, hexagonal crystals, for example. Further, among hexagonal crystals, 4H, 6H, and so forth are known as typical polytypes.

In many cases, single crystal grows on the same type like 4H grows on a 4H type seed crystal (Patent Document 2).

SiC single crystal ingots manufactured with a manufacturing apparatus as described above have problems that cracking occurs, and that wafers are broken or cracked during slicing process.

### CITATION LIST

### PATENT LITERATURE

Patent Document 1: Japanese Unexamined Patent Application Publication No. 2000-191399
Patent Document 2: Japanese Unexamined Patent Application Publication No. 2005-239465

### SUMMARY OF INVENTION

### TECHNICAL PROBLEM

The present invention has been made in view of the above-described problems. An object of the present invention is to provide a method and apparatus for manufacturing a silicon carbide single crystal to reduce breaking and cracking of the silicon carbide single crystal ingot and wafer.

### SOLUTION TO PROBLEM

To achieve the object, the present invention provides a method for manufacturing a silicon carbide single crystal by sublimating a silicon carbide raw material to grow a silicon carbide single crystal on a seed crystal substrate in an apparatus for growing a silicon carbide single crystal, the apparatus including at least a growth container and a heat-insulating container that surrounds the growth container and has a hole for temperature measurement, the method comprising:
measuring a temperature of the growth container via the hole for temperature measurement when the silicon carbide single crystal is grown; and
blocking the hole for temperature measurement with a blocking member when the silicon carbide single crystal is cooled after the growth of the silicon carbide single crystal is ended.

In this manner, after the silicon carbide single crystal growth is ended, when a silicon carbide single crystal is being cooled, blocking the hole for temperature measurement with a blocking member makes it possible to prevent heat from escaping through the hole, thereby making the temperature of the silicon carbide single crystal uniform during the cooling. Accordingly, a SiC single crystal ingot with less residual strain can be obtained such that the breaking and cracking are successfully suppressed.

Moreover, the present invention provides an apparatus for manufacturing a silicon carbide single crystal by growing the silicon carbide single crystal by a sublimation method, the apparatus comprising at least:
a growth container;
a heat-insulating container surrounding the growth container and having a hole for temperature measurement;
a heating heater; and
a blocking member configured to block the hole for temperature measurement.

Such an apparatus for manufacturing a silicon carbide single crystal is capable of blocking the hole for temperature measurement with a blocking member when a silicon carbide single crystal is being cooled, and thus preventing heat radiation through the hole when the silicon carbide single crystal is being cooled. Thereby, the temperature inside the silicon carbide single crystal can be made uniform during the cooling. Accordingly, the silicon carbide single crystal has less residual strain, and the breaking and cracking are successfully suppressed.

Additionally, the blocking member preferably comprises any material of carbon, titanium, and tantalum.

These materials can withstand a high temperature of 2000°C or more and block radiant light at the high temperature under vacuum.

More preferably, the blocking member further comprises a heat-insulating material having a carbon fiber, an alumina fiber, or a porous structure such as carbon foam.

The blocking member containing such a heat-insulating material has a higher heat-insulating effect and allows the temperature inside the crystal to be more uniform during the cooling.

Furthermore, the inventive apparatus for manufacturing a silicon carbide single crystal may comprise a movement mechanism configured to raise, lower, rotate, or slide the blocking member configured to block the hole for temperature measurement.

This enables measurement of the temperature of the growth container via the hole for temperature measurement when a silicon carbide single crystal is grown, whereas the hole for temperature measurement can be easily blocked with the blocking member when the silicon carbide single crystal is cooled after the growth of the silicon carbide single crystal is ended.

### ADVANTAGEOUS EFFECTS OF INVENTION

As described above, according to the inventive method and apparatus for manufacturing a silicon carbide single crystal, when a silicon carbide single crystal is cooled after the growth of the silicon carbide single crystal is ended, the hole for temperature measurement is blocked with the blocking member. This makes it possible to prevent heat radiation through the hole, thereby making the silicon carbide single crystal have uniform temperature during the cooling. Accordingly, a SiC single crystal ingot with less residual strain can be obtained such that the breaking and cracking are successfully suppressed.

### BRIEF DESCRIPTION OF DRAWINGS

FIG. 1 is a flowchart showing an example of the inventive method for manufacturing a silicon carbide single crystal.
FIG. 2 is a schematic cross-sectional view showing an example of the inventive apparatus for manufacturing a silicon carbide single crystal.
FIG. 3 is a schematic view for illustrating a case where a blocking member according to the present invention is slid to block a hole for temperature measurement.
FIG. 4 is a schematic view for illustrating a case where a blocking member according to the present invention is raised and lowered to block the hole for temperature measurement.
FIG. 5 shows a photograph for showing an exemplar wafer produced in Example.
FIG. 6 shows photographs for showing exemplar wafers produced in Comparative Example.
FIG. 7 is a graph showing stress distributions in the wafers of Example and Comparative Example.
FIG. 8 is a schematic cross-sectional view showing an example of a conventional apparatus for manufacturing a silicon carbide single crystal.
FIG. 9 is a flowchart showing an example of a conventional method for manufacturing a silicon carbide single crystal.
FIG. 10 is a schematic cross-sectional view showing heat transfer and temperature distribution in the vicinity of a hole for temperature measurement in the conventional method and apparatus for manufacturing a silicon carbide single crystal.
FIG. 11 is a schematic cross-sectional view showing a temperature distribution inside a SiC single crystal ingot that is grown by the conventional method and apparatus for manufacturing a silicon carbide single crystal.

### DESCRIPTION OF EMBODIMENTS

As described above, when a SiC single crystal is manufactured using a conventional apparatus for manufacturing a SiC single crystal, there have been problems that the SiC single crystal ingot is cracked, and the wafer is broken or cracked during slicing process.

The present inventors have diligently studied to solve the problems and consequently found that when a SiC single crystal ingot is being cooled, blocking a hole for temperature measurement can prevent heat radiation through the hole, and thereby make the temperature inside the ingot uniform during the cooling, so that the breaking and cracking of the SiC single crystal ingot and wafer are successfully reduced. This finding has led to the completion of the present invention.

Hereinafter, the present invention will be described in detail with reference to the drawings as an example of embodiments. However, the present invention is not limited thereto.

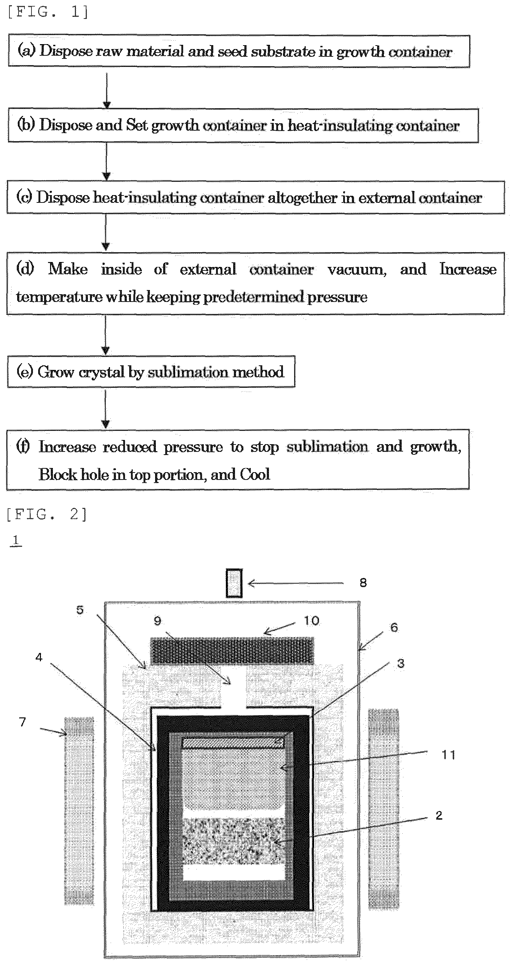

FIG. 1 is a flowchart showing an example of the inventive method for manufacturing a silicon carbide single crystal.

FIG. 2 is a schematic cross-sectional view of an example of the inventive apparatus for manufacturing a silicon carbide single crystal.

First, the inventive apparatus for manufacturing a silicon carbide single crystal will be described.

As shown in FIG. 2, an apparatus 1 for manufacturing a silicon carbide single crystal according to the present invention includes a growth container 4 which is made of carbon graphite, and which has a container main body for housing a SiC raw material 2 and a lid on which a SiC seed substrate 3 is disposed. Moreover, the apparatus 1 for manufacturing a silicon carbide single crystal includes a heat-insulating container 5 made of a heat-insulating material outside the growth container 4, and further includes, outside the heat-insulating container 5, an external container 6 such as a quartz tube or a vacuum chamber for reducing the pressure of the growth container 4, and a heater 7 for heating the SiC raw material 2. Furthermore, the apparatus 1 includes a thermometer 8 such as a temperature-measurement sensor for measuring the temperature inside the growth container 4. The heat-insulating container 5 has a hole 9 for temperature measurement in a top portion thereof. Additionally, the apparatus 1 includes a supply port for supplying an inert gas such as Ar and a discharge port for discharging the inert gas, which are not shown, during SiC crystal growth. The configuration described so far is substantially the same as that of the conventional apparatus. Nevertheless, in the present invention, a blocking member 10 configured to block the hole 9 for temperature measurement in the heat-insulating container 5 is installed.

This blocking member 10 is configured to be movable such that: the hole 9 for temperature measurement is opened so as to enable the temperature measurement of the growth container 4 through the hole 9 when a SiC single crystal is grown; and the hole 9 is closed when the growth is ended and the single crystal is cooled.

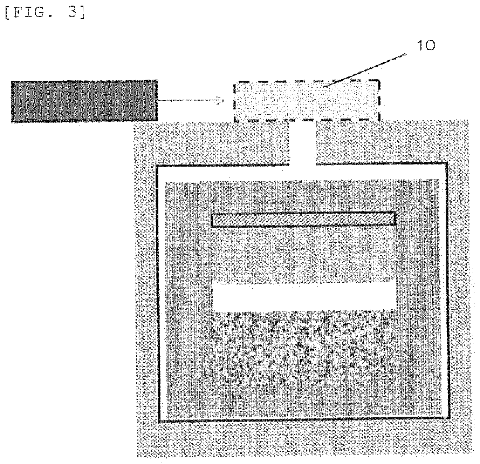

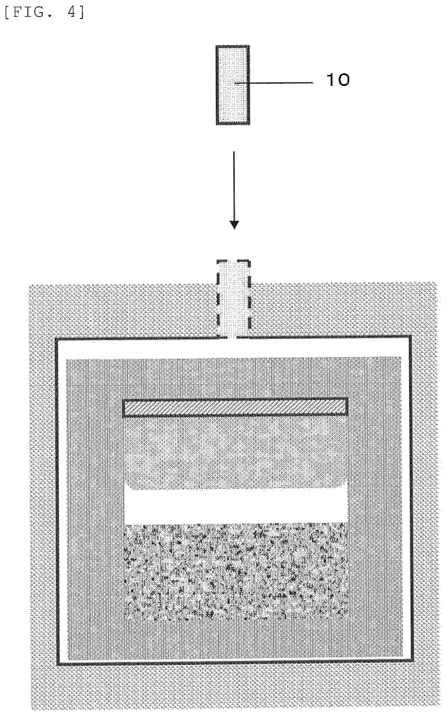

In addition, a movement mechanism for the blocking member 10 is not particularly limited, and can be such a mechanism configured to raise, lower, rotate, or slide the blocking member 10 with a motor, a hydraulic cylinder, an air cylinder, etc. For example, FIG. 3 shows a case where the blocking member 10 is slid, and FIG. 4 shows a case where the blocking member 10 is raised and lowered and thereby fitted into the hole.

The blocking member 10 can be made of a material such as carbon, titanium, or tantalum. These materials are capable of withstanding a high temperature of 2000°C or more and blocking radiant light at the high temperature under vacuum.

Additionally, the blocking member 10 preferably further contains a heat-insulating material composed of a carbon fiber, a heat-insulating material composed of an alumina fiber, or a heat-insulating material having a porous structure such as carbon foam. The blocking member containing such a heat-insulating material improves the heat-insulating effect and allows the temperature in the crystal to be more uniform during the cooling.

As described above, the inventive apparatus for manufacturing a silicon carbide single crystal is capable of easily blocking the hole 9 for temperature measurement with the blocking member 10 when a silicon carbide single crystal ingot 11 is cooled, thereby preventing heat radiation through the hole 9 during the cooling of the silicon carbide single crystal. This enables the temperature inside the silicon carbide single crystal to be uniform during the cooling. Thus, the silicon carbide single crystal has less residual strain, and the breaking and cracking are successfully suppressed.

Next, description will be given of the inventive method for manufacturing a silicon carbide single crystal with the inventive apparatus for manufacturing a silicon carbide single crystal described above.

As described in FIG. 1(a), the raw material 2 and the seed substrate 3 are disposed in the growth container 4. Next, as described in FIG. 1(b), the growth container 4 is disposed in the heat-insulating container 5. Next, as described in FIG. 1(c), the heat-insulating container 5 as a whole is disposed in the external container 6. Next, as described in FIG. 1(d), the inside of the external container 6 is made vacuum, and the temperature is raised while a predetermined pressure is being kept. Preferably, in this event, the temperature is 2000°C or more, and the pressure is 100 Torr (1.3×10² hPa) or less. Next, as described in FIG. 1(e), the SiC single crystal 11 is grown by a sublimation method. Note that when the SiC single crystal is grown, the temperature of the growth container 4 is measured via the hole 9 for temperature measurement provided in the heat-insulating container 5. In other words, the hole 9 for temperature measurement is opened during the SiC single crystal growth.

Finally, as described in FIG. 1(f), the growth is stopped by increasing the vacuum back pressure and decreasing the partial pressure of the sublimated gas as performed in the stopping process of a typical sublimation method. In the sublimation method described so far, the temperature is raised and the pressure is controlled in the same manner as in a typical conventional sublimation method. After the crystal growth is stopped, the hole 9 for temperature measurement is covered with the blocking member 10 as shown in FIG. 2.

According to the manufacturing method as described above, when the grown SiC single crystal ingot 11 is cooled, the hole 9 for temperature measurement is blocked. This makes it possible to prevent heat radiation through the hole 9, and the temperature inside the SiC single crystal ingot 11 is made uniform during the cooling. From this state, the resultant is restored to ambient temperature, so that a SiC single crystal ingot with less residual strain can be obtained. In this way, the inventive manufacturing method makes it possible to reduce the residual strain of the SiC single crystal ingot, and suppress the breaking and cracking.

### EXAMPLE

Hereinafter, the present invention will be more specifically described by showing Example and Comparative Example. However, the present invention is not limited thereto.

### (Example)

Using the apparatus 1 for manufacturing a silicon carbide single crystal shown in FIG. 2, a SiC single crystal with a diameter of 4 inches (100 mm) was grown under the following growth conditions by the inventive method for manufacturing a silicon carbide single crystal.

### <Conditions>

Seed crystal substrate... SiC single crystal substrate with a diameter of 4 inches (100 mm) having a main surface tilted from the {0001} plane by 4° in the <11-20> direction
Growth temperature... 2200°C
Pressure... 10 Torr (1.3×10 hPa)
Atmosphere... argon and nitrogen gases

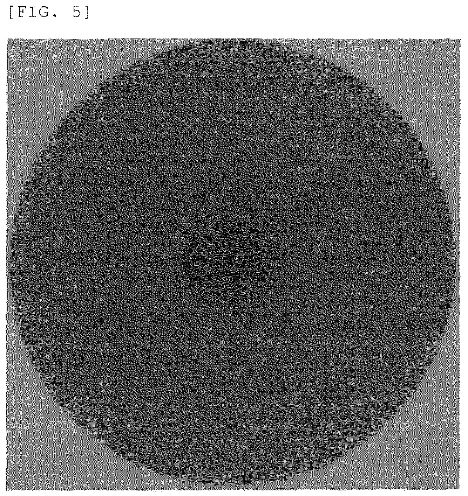

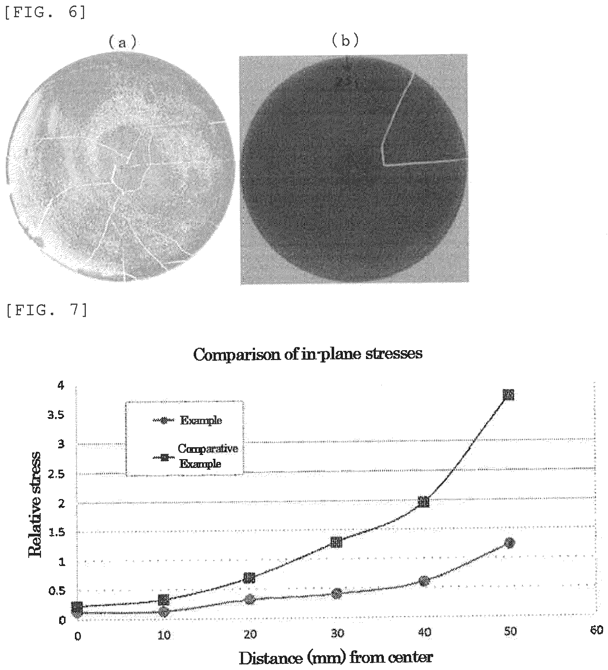

According to the procedure as described in FIG. 1, the hole 9 for temperature measurement was blocked with the blocking member 10 when a grown SiC single crystal was cooled. In this way, five SiC single crystal ingots were consequently prepared. As a result of examining the crack formation statuses of the five SiC single crystal ingots, no crack was formed in any of the five ingots. Four among these ingots were each sliced into four wafers to examine the crack formation statuses, and no crack was formed in all of the 16 wafers. FIG. 5 shows a photograph of such a wafer. Moreover, FIG. 7 shows the result of examining the stress distribution of the wafer. The stress distribution was measured by the Raman spectroscopy, and shown as relative stresses based on a small piece of SiC with no stress.

### (Comparative Example)

Five SiC single crystal ingots were prepared according to the procedure described in FIG. 9. The conditions were the same as those in Example, except that the hole for temperature measurement was not blocked during the cooling.

As a result of examining the crack formation statuses of the five SiC single crystal ingots, cracking was observed from one among the five ingots. Each of the four ingots with no cracks was sliced into four wafers to examine the crack formation statuses, and cracks were formed in all of the 16 wafers. Photographs of such wafers are shown in FIG. 6(a) (b). Moreover, FIG. 7 shows the result of examining the stress distributions of the wafers.

As apparent from the result shown in FIG. 7, unlike Comparative Example, the stress is not increased at positions apart from the center of the wafer in Example. This indicates that the inventive method and apparatus for manufacturing a silicon carbide single crystal make it possible to obtain a SiC single crystal ingot with less residual strain.

Moreover, it was found as described above that the present invention successfully reduces the breaking and cracking of the manufactured silicon carbide single crystal ingots in comparison with Comparative Example.

Further, FIGs. 5 and 6 revealed that the present invention successfully suppresses the breaking and cracking of the wafers.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a silicon carbide single crystal by sublimating a silicon carbide raw material to grow a silicon carbide single crystal on a seed crystal substrate in an apparatus for growing a silicon carbide single crystal, the apparatus including at least a growth container and a heat-insulating container that surrounds the growth container and has a hole for temperature measurement, the method comprising:
measuring a temperature of the growth container via the hole for temperature measurement when the silicon carbide single crystal is grown; and
blocking the hole for temperature measurement with a blocking member when the silicon carbide single crystal is cooled after the growth of the silicon carbide single crystal is ended.

2. An apparatus for manufacturing a silicon carbide single crystal by growing the silicon carbide single crystal by a sublimation method, the apparatus comprising at least:
a growth container;
a heat-insulating container surrounding the growth container and having a hole for temperature measurement;
a heating heater; and
a blocking member configured to block the hole for temperature measurement.

3. The apparatus for manufacturing a silicon carbide single crystal according to claim 2, wherein the blocking member comprises any material of carbon, titanium, and tantalum.

4. The apparatus for manufacturing a silicon carbide single crystal according to claim 3, wherein the blocking member further comprises a heat-insulating material having a carbon fiber, an alumina fiber, or a porous structure.

5. The apparatus for manufacturing a silicon carbide single crystal according to any one of claims 2 to 4, comprising a movement mechanism configured to raise, lower, rotate, or slide the blocking member configured to block the hole for temperature measurement.
